# EUROPÄISCHE PATENTSCHRIFT

(11) **EP 2 761 670 B1**
(45) Veröffentlichungstag und Bekanntmachung des Hinweises auf die Patenterteilung: **30.05.2018**
(21) Anmeldenummer: 12775650.0
(22) Anmeldetag: 28.09.2012
(51) Int. Cl.: H01L 31/042, H01L 31/18, F24J 2/52, H02S 20/00, H02S 30/10, H02S 40/32

(54) **RAHMENLOSES SOLARMODUL MIT MONTAGELÖCHERN UND VERFAHREN ZUR HERSTELLUNG EINES SOLCHEN SOLARMODULS**
FRAMELESS SOLAR MODULE WITH ASSEMBLY HOLES AND MANUFACTURING METHOD THEREOF
MODULE SOLAIRE SANS CADRE DOTÉ DE TROUS DE MONTAGE ET PROCÉDÉ DE FABRICATION D'UN TEL MODULE

(30) Priorität: 30.09.2011 EP 11183427
(43) Veröffentlichungstag der Anmeldung: 06.08.2014
(73) Patentinhaber: Saint-Gobain Glass France, 92400 Courbevoie (FR)
(72) Erfinder: HAPP, Thomas, 81825 München (DE); PHILIPP, Jan, Boris, 81673 München (DE)
(74) Vertreter: Gebauer, Dieter Edmund
(86) Internationale Anmeldenummer: PCT/EP2012/069295
(87) Internationale Veröffentlichungsnummer: WO 2013/045683

(56) Entgegenhaltungen:
- EP-A1- 0 525 225
- CN-A- 102 136 504
- DE-A1- 4 331 425
- DE-U1-202008 008 743
- DE-U1-202008 013 819
- JP-A- H11 200 575

## Beschreibung

Photovoltaische Schichtensysteme zur direkten Umwandlung von Sonnenlicht in elektrische Energie sind hinlänglich bekannt. Gemeinhin werden diese als "Solarzellen" bezeichnet, wobei sich der Begriff "Dünnschichtsolarzellen" auf Schichtensysteme mit geringen Dicken von nur wenigen Mikrometern bezieht, die Trägersubstrate für eine ausreichende mechanische Festigkeit benötigen. Bekannte Trägersubstrate umfassen anorganisches Glas, Kunststoffe (Polymere) oder Metalle, insbesondere Metalllegierungen, und können in Abhängigkeit von der jeweiligen Schichtdicke und den spezifischen Materialeigenschaften als starre Platten oder biegsame Folien ausgestaltet sein.

Hinsichtlich der technologischen Handhabbarkeit und des Wirkungsgrads haben sich Dünnschichtsolarzellen mit einer Halbleiterschicht aus amorphem, mikromorphem oder polykristallinem Silizium, Cadmium-Tellurid (CdTe), Gallium-Arsenid (GaAs) oder einer Chalkopyrit-Verbindung, insbesondere Kupfer-Indium/Gallium-Dischwefel/Diselenid, abgekürzt durch die Formel Cu(In,Ga)(S,Se)₂, als vorteilhaft erwiesen. Insbesondere Kupfer-Indium-Diselenid (CuInSe₂ bzw. CIS) zeichnet sich aufgrund seines an das Spektrum des Sonnenlichts angepassten Bandabstands durch einen besonders hohen Absorptionskoeffizienten aus.

Mit einzelnen Solarzellen können typischer Weise nur Spannungspegel von weniger als 1 Volt erreicht werden. Um eine technisch brauchbare Ausgangsspannung zu erhalten, werden eine Vielzahl Solarzellen in einem Solarmodul seriell miteinander verschaltet. Hierbei bieten Dünnschichtsolarmodule den besonderen Vorteil, dass die Solarzellen schon während der Schichtenherstellung in integrierter Form verschaltet werden können. In der Patentliteratur wurden Dünnschichtsolarmodule bereits mehrfach beschrieben. Lediglich beispielhaft sei auf die Druckschriften DE 4324318 C1 und EP 2200097 A1 verwiesen.

Bei der so genannten Substratkonfiguration werden die verschiedenen Schichten zur Herstellung der Solarzellen direkt auf ein Trägersubstrat aufgebracht, das mit einer vorderseitigen transparenten Deckschicht zu einem bewitterungsstabilen Verbund verklebt ("laminiert") wird.

In der Praxis werden Solarmodule auf die Dächer von Gebäuden montiert ("Aufdach-Montage") oder bilden einen Teil der Dachhaut ("Indach-Montage"). Weiterhin ist es üblich, Solarmodule als Fassaden- oder Wandelemente einzusetzen, insbesondere in Form freiaufgestellter oder freitragender (trägerloser) Glaskonstruktionen.

Bei der Aufdach-Montage werden die Solarmodule dachparallel an einer im Dach verankerten Modulhalterung montiert, wobei die Solarmodule beispielsweise durch Modulklemmen an der Modulhalterung befestigt werden. Die Solarmodule verfügen zu diesem Zweck über einen gewöhnlich aus Aluminium gefertigten Modulrahmen, an dem das Solarmodul befestigt werden kann. Die Modulhalterung umfasst in der Regel ein Montagegestell aus Aluminiumschienen, die beispielsweise durch Stahlanker auf Ziegeldächern oder Schrauben auf Wellplatten- oder Trapezblechdächern befestigt sind. Da bei der Aufdach-Montage die Dachhaut vollständig erhalten bleibt, müssen die Solarmodule im Unterschied zur Indach-Montage keine Dachfunktion übernehmen. Auch bei der Indach-Montage wird eine Modulhalterung eingesetzt, die an einer Dachunterkonstruktion befestigt wird. Um die Dichtigkeit zu gewährleisten, müssen die Fugen zwischen den Solarmodulen abgedichtet werden. Bei der Freiaufstellung ist eine Aufständerung vorgesehen, an der die Solarmodule befestigt werden. Bei freitragenden Konstruktionen werden die Solarmodule an den Modulrahmen miteinander verbunden.

In jüngerer Zeit werden zunehmend rahmenlose Solarmodule eingesetzt, welche ein verringertes Modulgewicht und geringere Fertigungskosten ermöglichen. Für die Montage werden die Solarmodule auf ihrer Rückseite mit einer Verstärkungsstrebe aus Stahl oder Aluminium versehen, welche typischer Weise auf das Trägersubstrat aufgeklebt wird. Über die Verstärkungsstreben können die rahmenlosen Solarmodule an einer Modulhalterung befestigt werden. Diese Montageart ist relativ aufwändig und durch die Verklebung verschleißanfällig. Zudem erlaubt sie keine ästhetisch ansprechende Lösung für freitragende Konstruktionen.

Die chinesische Druckschrift CN 102136504 A zeigt ein Solarmodul gemäß dem Oberbegriff von Patentanspruch 1. Die japanische Druckschrift JP H11 200575 A1 zeigt ein Solarmodul mit einem mittigen Befestigungsbolzen, bei dem die Solarzellen eine gleiche Solarzellfläche haben. Die vom Befestigungsbolzen beeinträchtigten Solarzellen haben eine voneinander verschiedene Form.

Demgegenüber besteht die Aufgabe der vorliegenden Erfindung darin, die herkömmliche Montage rahmenloser Solarmodule in vorteilhafter Weise weiterzubilden, wobei die Montage vereinfacht und die Montagekosten verringert werden sollen. Insbesondere sollen rahmenlose Solarmodule auch in Form freitragender Konstruktionen eingesetzt werden können. Diese und weitere Aufgaben werden nach dem Vorschlag der Erfindung durch ein Solarmodul, eine Montageanordnung sowie ein Verfahren zur Herstellung eines rahmenlosen Solarmoduls mit den Merkmalen der nebengeordneten Patentansprüche gelöst. Vorteilhafte Ausgestaltungen der Erfindung sind durch die Merkmale der Unteransprüche angegeben.

Erfindungsgemäß ist ein rahmenloses Solarmodul mit einem Trägersubstrat und einer damit verbundenen Deckschicht gezeigt. Zwischen dem Trägersubstrat und der Deckschicht befindet sich ein Schichtenaufbau, durch den eine Mehrzahl seriell verschalteter Solarzellen zur photovoltaischen Energieerzeugung gebildet wird. Das Trägersubstrat und die Deckschicht bestehen beispielsweise aus anorganischem Glas, Polymeren oder Metalllegierungen und sind in Abhängigkeit von Schichtdicke und Materialeigenschaften vorzugsweise als starre Platten ausgestaltet.

Bei dem Solarmodul handelt es sich um ein Dünnschichtsolarmodul mit in integrierter Form seriell verschalteten Dünnschichtsolarzellen. Der Schichtenaufbau umfasst eine Rückelektroden-, eine Frontelektroden- und eine Halbleiterschicht. Vorzugsweise besteht die Halbleiterschicht aus einer Chalkopyrit-Verbindung, bei der es sich beispielsweise um einen I-III-VI-Halbleiter aus der Gruppe Kupfer-Indium/Gallium-Dischwefel/Diselenid (Cu(InGa)(SSE)₂), beispielsweise Kupfer-Indium-Diselenid (CuInSe₂ bzw. CIS) oder verwandte Verbindungen, handeln kann.

Wesentlich hierbei ist, dass das Trägersubstrat und/oder die Deckschicht jeweils mit einer Mehrzahl Montagelöcher zur Montage des Solarmoduls an einer Modulhalterung oder zur Verbindung mit zumindest einem weiteren Solarmodul versehen ist/sind. Das erfindungsgemäße Solarmodul ermöglicht dadurch in besonders vorteilhafter Weise eine technisch wenig aufwändige, vielfältig variierbare und kostengünstige Montage des Solarmoduls an der Modulhalterung, sowie eine ästhetisch ansprechende Verbindung von Solarmodulen in einer freitragenden Konstruktion. Insbesondere können die Solarmodule dabei mit kleiner Dehnungsfuge ohne weitere Tragelemente nebeneinander montiert werden.

Hierbei sind die Montagelöcher jeweils in einer beschichtungsfreien Zone
ausgebildet. Durch diese Maßnahme ist eine gezielte Positionierung der Montagelöcher für eine zuverlässige und sichere Montage des Solarmoduls ermöglicht, welche im Unterschied zur herkömmlichen Befestigungsmethode gerahmter Solarmodule nicht auf den Modulrahmen eingeschränkt ist. Zudem ist es nicht erforderlich, dass ein relativ breiter, beschichtungsfreier Randbereich des Solarmoduls zum Ausbilden der Montagelöcher vorgesehen werden muss, so dass die zur Herstellung der Solarzellen zur Verfügung stehende Fläche des Trägersubstrats effizient nutzbar ist.

Im erfindungsgemäßen Solarmodul ist der photovoltaisch aktive Bereich mit beschichtungsfreien Zonen versehen, in denen die Montagelöcher angeordnet sind. Typischer Weise ist der photovoltaisch aktive Bereich rechteckförmig ausgebildet. Die beschichtungsfreien Zonen sind als Ausnehmungen bzw. Aussparungen des photovoltaisch aktiven Bereichs ausgebildet. Insofern wird durch die beschichtungsfreien Zonen der photoltaisch aktive Bereich des Solarmoduls verringert.

Das Solarmodul weist erste Solarzellen und (von den ersten Solarzellen verschiedene) zweite Solarzellen auf, wobei die zweiten Solarzellen jeweils eine Form haben, die von der Form der ersten Solarzellen verschieden ist. Die ersten Solarzellen sind durch die beschichtungsfreien Zonen nicht beeinträchtigt, wobei die ersten Solarzellen jeweils aus einem Abschnitt des Schichtenaufbaus hergestellt sind, in dem sich keine beschichtungsfreie Zone befindet. Erfindungsgemäß verfügt das Solarmodul über zueinander gleiche (in der Modulebene eine zueinander gleiche Rechteckform aufweisende) erste Solarzellen.

Zudem verfügt das Solarmodul über zweite Solarzellen, deren Form aufgrund der beschichtungsfreien Zonen in Bezug auf die Form der ersten Solarzellen verändert ist. Die zweiten Solarzellen sind jeweils aus einem Abschnitt des Schichtenaufbaus hergestellt, in dem sich wenigstens eine beschichtungsfreie Zone befindet. Jede zweite Solarzelle hat somit eine andere Form als eine erste Solarzelle. Die zweiten Solarzellen haben eine zueinander gleiche Rechteckform. Bei den beschichtungsfreien Zonen handelt es sich beispielsweise jeweils um eine entschichtete Zone, d.h. um eine Zone, in welcher der Schichtenaufbau zur Formung der Solarzellen entfernt wurde. Denkbar ist jedoch auch, dass in den beschichtungsfreien Zonen kein Schichtenaufbau aufgebracht wird, was beispielsweise durch Maskierung beim Aufbringen des Schichtenaufbaus erreicht werden kann. Hierbei ist es von besonderem Vorteil, dass die seriell miteinander verschalteten Solarzellen des Solarmoduls trotz des Vorsehens beschichtungsfreier Zonen innerhalb des photovoltaisch aktiven Bereichs des Solarmoduls eine zueinander gleiche bzw. selbe Solarzellenfläche aufweisen. Erfindungsgemäß hat jede Solarzelle eine Solarzellenfläche, die der Solarzellenfläche einer jeden anderen Solarzelle des Solarmoduls entspricht. Die ersten Solarzellen haben durch die zueinander gleiche Form ohnehin eine selbe Solarzellenfläche. Die zweiten Solarzellen haben eine zueinander gleiche Form, so dass deren Solarzellenflächen auch zueinander gleich sind. Jedenfalls haben die zweiten Solarzellen jeweils eine Form die von der Form der ersten Solarzellen verschieden ist, wobei alle Solarzellen (erste und zweite Solarzellen) des Solarmoduls eine zueinander gleiche Solarzellenfläche haben. Somit hat jede zweite Solarzelle eine Solarzellenfläche, die der Solarzellenfläche einer ersten Solarzelle entspricht. Erfindungsgemäß haben die rechteckigen zweiten Solarzellen zu diesem Zweck jeweils eine größere Breite (kürzere Abmessung) als die rechteckigen ersten Solarzellen), wobei die Länge (längere Abmessung) der zweiten Solarzellen aufgrund der beschichtungsfreien Zonen jeweils kürzer ist als

die Länge der ersten Solarzellen. Durch diese Maßnahme kann erreicht werden, dass die Solarzellen in einem zumindest annähernd gleichen Arbeitspunkt ihrer Kennlinie betrieben werden, so dass der Wirkungsgrad der von den beschichtungsfreien Zonen betroffenen Solarzellen gegenüber den anderen Solarzellen nicht verschlechtert ist.

Vorzugsweise ist an jedem Montageloch eine das Montageloch umlaufend zum Schichtenaufbau hin abdichtende Dichtmasse zwischen Trägersubstrat und Deckschicht angeordnet, wodurch das Eindringen von Feuchtigkeit und Schmutz in den photovoltaisch aktiven Bereich verhindert werden kann.

Bei einer weiteren vorteilhaften Ausgestaltung des erfindungsgemäßen rahmenlosen Solarmoduls verfügt das Trägersubstrat oder die in Form einer starren Deckplatte ausgebildete Deckschicht über einen überstehenden Randabschnitt, in dem die Montagelöcher ausgebildet sind. Somit weist das Trägersubstrat einen überstehenden Randabschnitt auf, der in Bezug auf die Deckschicht übersteht. Alternativ weist die Deckschicht einen überstehenden Randabschnitt auf, der in Bezug auf das Trägersubstrat übersteht.

Besonders vorteilhaft wird der Randabschnitt von der front- bzw. lichteintrittsseitigen Deckschicht gebildet, wodurch erreicht werden kann, dass die Prozessierung der Solarzellen unverändert bleibt und lediglich im so genannten Backend das Trägersubstrat mit den Solarzellen mit der mit den Montagelöchern versehenen Deckschicht laminiert wird. Zudem wird die photovoltaisch aktive Fläche der Solarzellen nicht beeinträchtigt.

Die Erfindung erstreckt sich weiterhin auf eine Montageanordnung mit wenigstens einem wie oben beschriebenen rahmenlosen Solarmodul, bei welcher das Solarmodul durch die Montagelöcher durchsetzende Befestigungselemente, beispielsweise Schraubbolzen, an der Modulhalterung montiert ist. Vorteilhaft ist zur Verringerung der mechanischen Belastung an den Montagelöchern jeweils eine Lage aus elastisch nachgiebigem Material, beispielsweise Gummi, zwischen dem Befestigungselement und dem Solarmodul und/oder zwischen dem Solarmodul und der Modulhalterung angeordnet.

Ferner erstreckt sich die Erfindung auf eine Montageanordnung mit wie oben beschriebenen rahmenlosen Solarmodulen, bei welcher benachbarte Solarmodule durch Verbindungselemente, welche an den Solarmodulen durch die Montagelöcher durchsetzende Befestigungselemente, beispielsweise Schraubbolzen, montiert sind, miteinander verbunden sind. Vorteilhaft sind Fugen zwischen benachbarten Solarmodulen durch Dichtelemente abgedichtet. Des Weiteren erstreckt sich die Erfindung auf ein Verfahren zur Herstellung eines erfindungsgemäßen rahmenlosen Dünnschichtsolarmoduls, mit einem Trägersubstrat und einer damit verbundenen Deckschicht, zwischen denen sich ein Schichtenaufbau befindet, durch den eine Mehrzahl seriell verschalteter Solarzellen zur photovoltaischen Energieerzeugung gebildet wird. Im erfindungsgemäßen Verfahren wird das Trägersubstrat und/oder die Deckschicht mit Montagelöchern zur Montage des Solarmoduls an einer Modulhalterung oder zur Verbindung mit zumindest einem weiteren Solarmodul versehen. In verfahrenstechnischer Hinsicht kann es von Vorteil sein, wenn die Montagelöcher vor dem Aufbringen des Schichtenaufbaus auf das Trägersubstrat im Trägersubstrat und/oder in der Deckschicht ausgebildet werden. Erfindungsgemäß wird der Schichtenaufbau in die Montagelöcher enthaltenden oder zur Ausbildung der Montagelöcher vorgesehenen beschichtungsfreien Zonen entfernt, wodurch gleichermaßen ein verfahrenstechnischer Vorteil erreicht werden kann. Vorzugsweise wird an jedem Montageloch eine das Montageloch umlaufend zum Schichtenaufbau hin abdichtende Dichtmasse zwischen Trägersubstrat und Deckschicht angeordnet. Weiterhin kann es von Vorteil sein, wenn in die Montagelöcher jeweils eine Dichtmasse eingebracht wird.

### Kurze Beschreibung der Zeichnungen

Die Erfindung wird nun anhand von Ausführungsbeispielen näher erläutert, wobei Bezug auf die beigefügten Figuren genommen wird. Es zeigen:
- Fig. 1: in einer schematischen Aufsicht eine erfindungsgemäße Montageanordnung zur Aufdachbzw. Indach-Montage von Solarmodulen;
- Fig. 2A-2C: schematische Detaildarstellungen zur Veranschaulichung der Montagelöcher der Solarmodule von Fig. 1;
- Fig. 3A-3B: schematische Schnittdarstellungen im Bereich der Montagelöcher zur Veranschaulichung der Montage der Solarmodule von Fig. 1;
- Fig. 4A-4B: schematische Aufsichten zur Veranschaulichung von Solarzellen gleicher Solarzellenfläche in den Solarmodulen von Fig. 1;
- Fig. 5: in einer Aufsicht eine in Form einer freitragenden Konstruktion ausgebildete erfindungsgemäße Montageanordnung;
- Fig. 6A-6B: schematische Schnittdarstellungen im Bereich der Montagelöcher zur Veranschaulichung der Montage der Solarmodule von Figur 5;
- Fig. 7A-7B: in einer schematischen Aufsicht und Schnittdarstellung eine weitere erfindungsgemäße Montageanordnung.

### Ausführliche Beschreibung der Zeichnungen

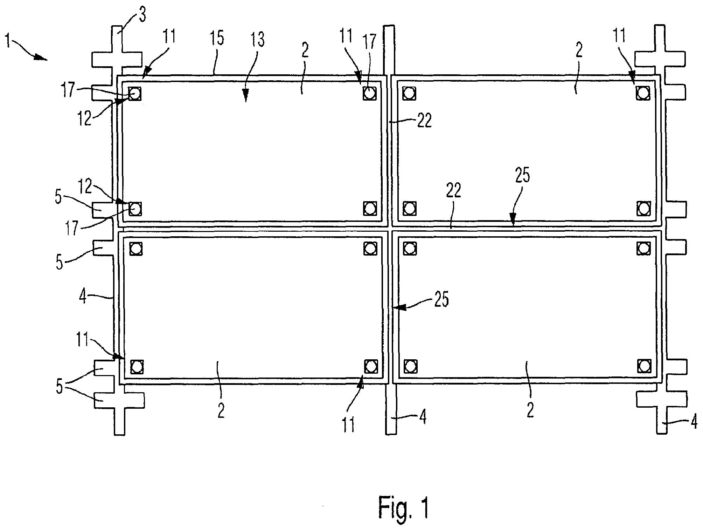

Seien zunächst Fig. 1, 2A-2C und 3A-3B betrachtet. Fig. 1 veranschaulicht den Aufbau einer insgesamt mit der Bezugszahl 1 bezeichneten Montageanordnung 1, bei welcher eine Mehrzahl Solarmodule 2, bei welchen es sich hier beispielsweise um Dünnschichtsolarmodule handelt, an einer Modulhalterung 3 montiert ist. Obgleich in Fig. 1 vier Solarmodule 2 gezeigt sind, versteht es sich, dass die Montageanordnung 1 gleichermaßen eine größere oder kleinere Anzahl Solarmodule 2 enthalten kann. Die Solarmodule 2 sind wie üblich jeweils als rechteckförmige Flächenkörper ausgebildet.

Die Modulhalterung 3 dient für eine Aufdach- oder Indach-Montage der Solarmodule 2 und umfasst eine Mehrzahl paralleler Tragschienen 4, welche beispielsweise aus Aluminium gefertigt sind. Die Tragschienen 4 sind beispielsweise durch Schrauben oder Stahlanker an einem nicht dargestellten Gebäudedach (bei Aufdach-Montage) oder an einer Dachunterkonstruktion (bei Indach-Montage) verankert. Jede Tragschiene 4 verfügt über eine Mehrzahl Modulhalter 5, welche senkrecht zur Tragschiene 4 entlang der Schienenerstreckung verteilt angeordnet sind und für eine Montage der Solarmodule 5 dienen.

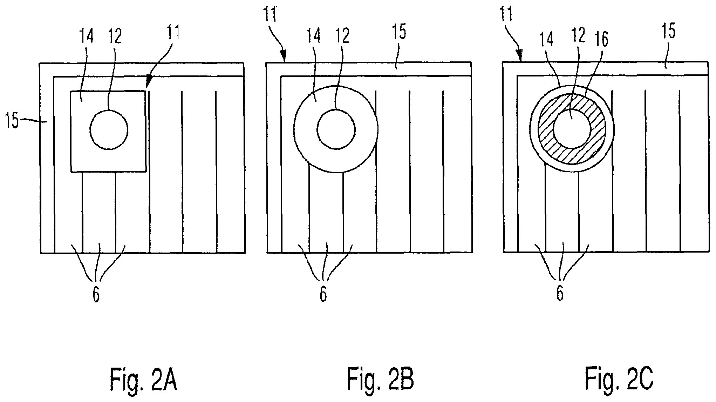

Wie den Figuren 2A-2C entnommen werden kann, umfassen die Solarmodule 2 jeweils eine Mehrzahl in integrierter Form seriell miteinander verschalteter Solarzellen 6 mit einer rechteckförmigen Solarzellenfläche. Jedes Solarmodul 2 verfügt in der Regel über eine Vielzahl (z.B. ca. 100) Solarzellen 6.

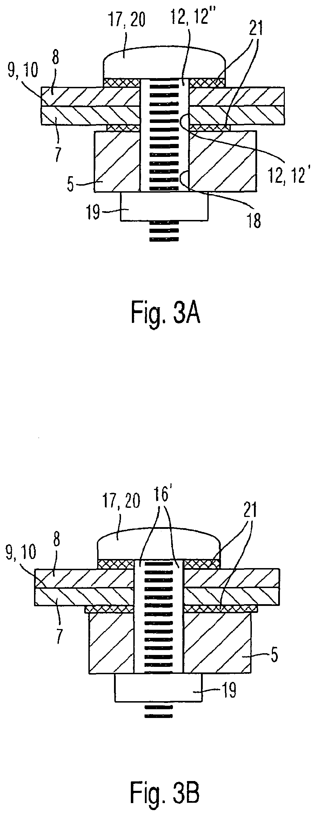

Wie in Fig. 3A-3B angedeutet, basieren die Solarmodule 2 hier beispielsweise auf der so genannten Substratkonfiguration und umfassen ein elektrisch isolierendes, rückseitiges Trägersubstrat 7 mit einem darauf aufgebrachten Schichtenaufbau 9 zur Ausbildung der Solarzellen 6, sowie eine front- bzw. lichteintrittseitige Deckplatte 8, die mit dem Trägersubstrat 7 verbunden ist. Das starre Trägersubstrat 7 mit dem strukturierten Schichtenaufbau 9 ist mit der starren Deckplatte 8 durch eine Klebschicht 10, die beispielsweise Polyvinylbutyral (PVB) oder Ethylenvinylacetat (EVA) enthält, verklebt ("laminiert").

Der nicht näher dargestellte Schichtenaufbau 9 umfasst eine auf der Vorderseite des Trägersubstrats 7 angeordnete Rückelektrodenschicht aus einem lichtundurchlässigen Metall, beispielsweise Molybdän, eine auf der Rückelektrodenschicht abgeschiedene, photovoltaisch aktive Absorberschicht, welche beispielsweise einen p-leitenden Chalkopyrithalbleiter, wie eine Verbindung der Gruppe Kupfer-Indium-Diselenid (CuInSe₂), insbesondere Natrium (Na)-dotiertes Cu(In,Ga)(S,Se)₂ enthält, eine Pufferschicht, und eine auf die Pufferschicht aufgebrachte Frontelektrodenschicht, welche für Strahlung in dem für den Halbleiter empfindlichen Spektralbereich transparent ist und beispielsweise auf einem dotierten Metalloxid, beispielsweise n-leitendes, Aluminium-dotiertes Zinkoxid, basiert. Der Schichtenaufbau 9 ist mit an sich bekannten Verfahren in die Solarzellen 6 unterteilt, wobei die Unterteilung unter Einsatz einer geeigneten Strukturierungstechnologie wie Laserschreiben durch Einschnitte erfolgt. Da der grundsätzliche Aufbau eines solchen Solarmoduls 2 mit seriell verschalteten Solarzellen 6 dem Fachmann an sich bekannt ist, wird hier nicht näher darauf eingegangen.

Das starre Trägersubstrat 7 besteht hier beispielsweise aus Glas mit einer relativ geringen Lichtdurchlässigkeit, wobei gleichermaßen andere isolierende Materialien mit genügender Festigkeit, sowie inertem Verhalten gegenüber den durchgeführten Prozessschritten eingesetzt werden können. Die starre Deckplatte 8 enthält beispielsweise gehärtetes, extraweißes Glas mit geringem Eisengehalt.

Die Solarmodule 2 sind in ihren Eckbereichen 11 jeweils mit einem in Form einer Durchbrechung ausgebildeten Montageloch 12 versehen, wobei die Montagelöcher 12 innerhalb eines photovoltaisch aktiven Bereichs 13 der Solarzellen 6 ausgebildet sind. Um die Montagelöcher 12 herum ist jeweils eine beschichtungsfreie Zone 14 (Ausnehmung bzw. Aussparung des Schichtenaufbaus 9) ausgebildet, in denen sich demnach kein Schichtenaufbau 9 befindet. Erfindungsgemäß haben die beschichtungsfreien Zonen 14 eine rechteckige Form, wie in der Fig. 2A veranschaulicht. Wie in den Fig. 2B und 2C veranschaulicht, können die beschichtungsfreien Zonen 14 eine runde Form haben, was jedoch kein Teil der Erfindung ist. Wie in Fig. 2C veranschaulicht, wird vorzugsweise eine Dichtmasse 16 aus beispielsweise Butylkautschuk um die Montagelöcher 12 herum zwischen Trägersubstrat 7 und Deckplatte 8 angeordnet, wodurch eine umlaufende Randversiegelung der Montagelöcher 12 erreicht werden kann.

Bei einer bevorzugten Herstellungsweise des Solarmoduls 2 wird auf das bereits mit vorgebohrten Montagelöchern 12' versehene Trägersubstrat 7 der Schichtenaufbau 9 aufgebracht und das Trägersubstrat 7 anschließend mit der bereits mit vorgebohrten Montagelöchern 12'' versehenen Deckplatte 8 laminiert. Dabei sind die Montagelöcher 12' des Trägersubstrats 7 fluchtend zu den Montagelöchern 12' der Deckplatte 8 angeordnet. Vor dem Laminieren wird der Schichtenaufbau 9 in den beschichtungsfreien Zonen 14 beispielsweise mechanisch-abrasiv mittels eines Reibrads entfernt. Die Entschichtung erfolgt vorteilhaft zusammen mit einer Randentschichtung einer Randzone 15 des Solarmoduls 2. Zudem wird die Dichtmasse 16 um die Montagelöcher 12 herum angeordnet, welche vorteilhaft aus einem Material besteht, das beim Laminieren aufschmilzt um nach Verfestigung eine Randversiegelung der Montagelöcher 12 zu formen. Bei einer alternativen Herstellungsweise werden die Montagelöcher 12 nachträglich im laminierten Solarmodul 2 erzeugt, beispielsweise durch Laserbohren. Vorteilhaft werden die beschichtungsfreien Zonen 14 hierbei vor dem Laminieren entschichtet und die Dichtmasse 16 im Bereich der zu erzeugenden Montagelöcher 12 angeordnet.

Denkbar ist auch, die beschichtungsfreien Zonen 14 nicht durch nachträgliche Entschichtung, sondern durch Maskieren während des Aufbringens des Schichtenaufbaus 9 auf das Trägersubstrat 7 auszubilden.

In den Figuren 3A-3B ist die Montage eines Solarmoduls 2 an einem Modulhalter 5 mittels einer Schraubverbindung veranschaulicht. Der Modulhalter 5 ist zu diesem Zweck mit einer Halterbohrung 18 versehen, die fluchtend zum Montageloch 12 angeordnet ist. Für eine Montage wird ein das Montageloch 12 und die Halterbohrung 18 durchsetzender Schraubbolzen 17 in Stellung gebracht, der mit einer Gegenmutter 19 verschraubt wird. Der Schraubbolzen 17 liegt mit seinem Bolzenkopf 20 der Vorderseite des Solarmoduls 2 an, das Solarmodul 2 liegt mit seiner Rückseite dem Modulhalter 5 auf. Durch Zwischenlagen 21 aus einem elastischen Material, beispielsweise Gummi, zwischen Bolzenkopf 20 und Solarmodul 2 sowie zwischen Solarmodul 2 und Modulhalter 5 können lokal überhöhte mechanische Spannungen vermindert werden. Wie in Fig. 3B gezeigt, kann vor dem Einstecken der Schraubbolzen 17 eine Dichtmasse 16' in die Montagelöcher 12 eingebracht werden, um ein zusätzliche Abdichtung der Montagelöcher 12 zu erreichen. Gegebenenfalls kann dann auf die Randversiegelung durch die Dichtmasse 16 zwischen Trägersubstrat 7 und Deckplatte 8 verzichtet werden.

Wie in Fig. 1 gezeigt, sind in der Montageanordnung 1 die Solarmodule 2 nebeneinander entlang zweier orthogonaler Raumrichtungen angeordnet, wobei zwischen benachbarten Solarmodulen 2 jeweils eine Fuge 25 verbleibt. In die Fugen 25 ist jeweils eine Abdichtungsleiste 22 aus beispielsweise Gummi eingebracht, durch welche insbesondere bei einer Indach-Montage die Dichtigkeit der Montageanordnung 1 sichergestellt werden kann. Bei der Abdichtungsleiste 22 kann es sich beispielsweise auch um ein Fassadenelement handeln.

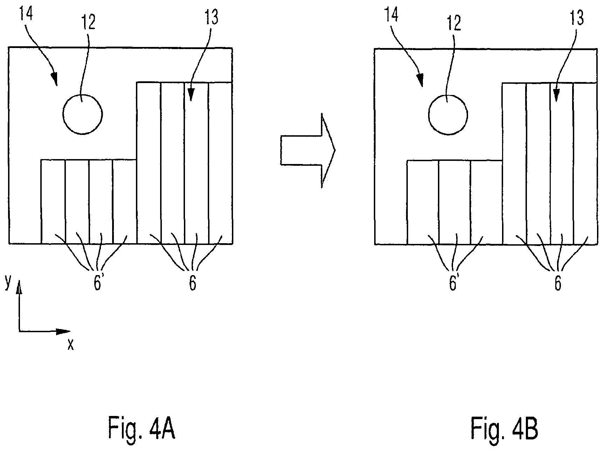

Es sei nun Fig. 4A betrachtet. Wie anhand obiger Ausführungen erkennbar ist, werden in den Solarmodulen 2 die Montagelöcher 12 im photovoltaisch aktiven Bereich 13 der Solarzellen 6 ausgebildet, was zur Folge hat, dass die Solarzellen 6 bei gleicher Breite (entlang x-Richtung) eine unterschiedliche Solarzellenfläche aufweisen. Demnach wird durch eine beschichtungsfreie Zone 14 die jeweilige Solarzellenfläche von beispielsweise vier Solarzellen 6' (in der Beschreibungseinleitung als "zweite Solarzellen" bezeichnet) gegenüber der jeweiligen Solarellenfläche der an die beschichtungsfreie Zone 14 angrenzenden Solarzellen 6 (in der Beschreibungseinleitung als "erste Solarzellen" bezeichnet) verringert. Die (ersten) Solarzellen 6 haben somit eine zueinander gleiche Form und Solarzellenfläche. Ebenso haben die (zweiten) Solarzellen 6' eine zueinander gleiche Form und Solarzellenfläche. Jedoch sind die Form und Solarzellenfläche einer (zweiten) Solarzelle 6' verschieden von der Form und Solarzellenfläche einer (ersten) Solarzelle 6.

Dies hat in nachteiliger Weise zur Folge, dass die (zweiten) Solarzellen 6' bei Belichtung weniger Spannung liefern als die benachbarten (ersten) Solarzellen 6 und in einem anderen Arbeitspunkt der Kennlinie betrieben werden, so dass der Wirkungsgrad der Solarzellen 6' verringert sein kann. Um dies zu vermeiden, ist es vorteilhaft, wenn im Solarmodul 2 alle Solarzellen 6, 6' eine zueinander gleiche Solarzellenfläche haben. Wie in Fig. 4B veranschaulicht, kann dies dadurch erreicht werden, dass die von der beschichtungsfreien Zone 14 betroffenen (zweiten) Solarzellen 6' zwar eine kürzere Länge (in y-Richtung), jedoch eine größere Breite (in x-Richtung) als die (ersten) Solarzellen 6 haben. Somit können alle Solarzellen 6 in einem selben, insbesondere optimalen Arbeitspunkt der Kennlinie betrieben werden.

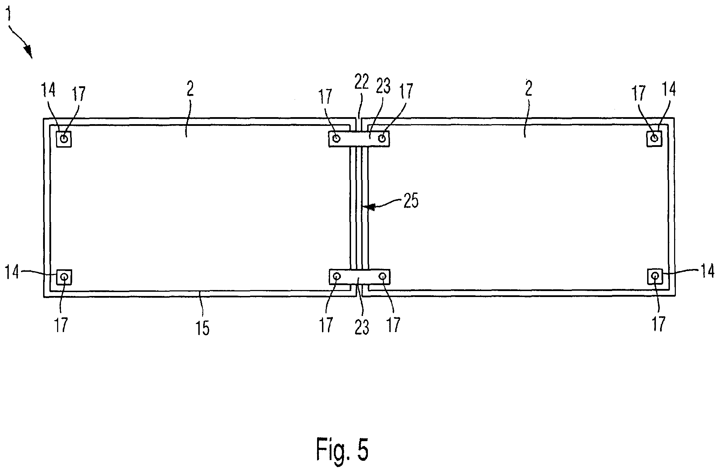

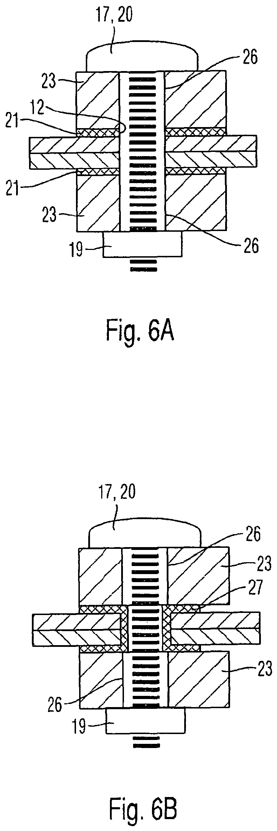

In Figuren 5, 6A und 6B ist anhand einer schematischen Aufsicht und Schnittansichten im Bereich der Montagelöcher 12 der Aufbau einer weiteren erfindungsgemäßen Montageanordnung 1 gezeigt, die als freitragende Konstruktion ausgebildet ist. Um unnötige Wiederholungen zu vermeiden, werden lediglich die Unterschiede zur vorigen Montageanordnung erläutert und ansonsten wird auf die dort gemachten Ausführungen Bezug genommen.

In der freitragenden Konstruktion sind die Solarmodule 2 mit einer kleinen Fuge 25 in einer Reihe nebeneinander angeordnet. Benachbarte Solarmodule 2 sind jeweils auf ihrer Ober- und Unterseite durch starre Verbindungslaschen 23 fest miteinander verbunden, wobei die Verbindungslaschen 23 jeweils die Fugen 25 benachbarter Solarmodule 2 überspannen. Eine Befestigung der Verbindungslaschen 23 an den Solarmodulen 2 erfolgt durch Schraubverbindungen, wobei die Verbindungslaschen 23 zu diesem Zweck mit Laschenbohrungen 26 ausgestattet sind, die fluchtend zu den Montagelöchern 12 angeordnet sind. Jedes Montageloch 12 und die beiden benachbarten Laschenbohrungen 26 werden von einem Schraubbolzen 17 durchsetzt, der mit einer Gegenmutter 19 verschraubt ist (siehe Fig. 6A-6B). Wie in Fig. 6A gezeigt, ist eine Zwischenlage 21 aus einem elastischen Material, beispielsweise Gummi, jeweils zwischen einem Bolzenkopf 20 und dem Solarmodul 2 sowie zwischen dem Solarmodul 2 und dem Modulhalter 5 vorgesehen. Wie in Fig. 6B gezeigt, können die beiden Zwischenlagen 21 innerhalb des Montagelochs 12 miteinander verbunden und in Form eines Dichtstücks 27 als eine das Montageloch 12 auskleidende, zusammenhängende Struktur ausgebildet sein. Durch das Dichtstück 27 kann in vorteilhafter Weise eine Randversiegelung des Montagelochs 12 erreicht werden, so dass gegebenenfalls auf eine Randversiegelung durch eine Dichtmasse 16 zwischen dem Trägersubstrat 7 und der Dichtplatte 8 im Bereich der Montagelöcher 12 verzichtet werden kann. Die Verbindungslaschen 23 ermöglichen in einfacher und kostengünstiger Weise den Aufbau einer ästhetisch ansprechenden, freitragenden Konstruktion aus den Solarmodulen 2. In den Fugen 25 ist jeweils eine Abdichtungsleiste 22 angeordnet, um die Dichtigkeit der Montageanordnung 1 zu gewährleisten.

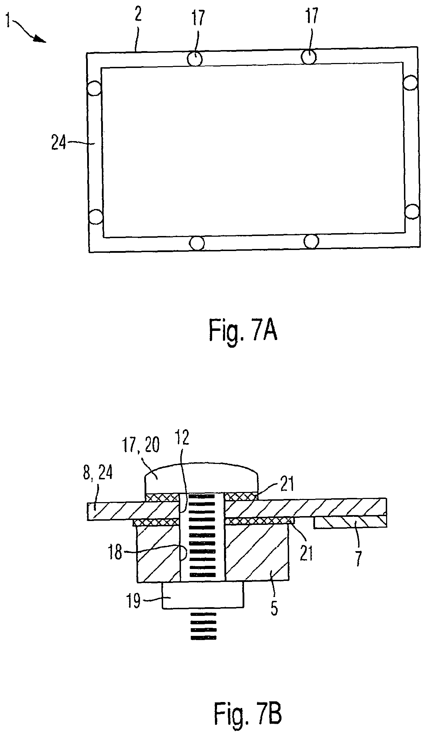

In Fig. 7A-7B ist anhand einer Aufsicht und einer Schnittansicht im Bereich eines Montagelochs 12 der Aufbau einer weiteren erfindungsgemäßen Montageanordnung 1 gezeigt, die gleichermaßen zur Aufdach-, Indach-Montage oder als freitragende Konstruktion geeignet ist. Um unnötige Wiederholungen zu vermeiden, werden lediglich die Unterschiede zu der anhand der Figuren 1, 2A-2C, 3A-3B und 4A-4B veranschaulichten Montageanordnung 1 erläutert und ansonsten wird auf die dort gemachten Ausführungen Bezug genommen.

Demnach verfügt das Solarmodul 2 über eine Deckplatte 8, die einen gegenüber dem Trägersubstrat 7 überstehenden, umlaufenden Randabschnitt 24 aufweist und somit größer ist als das Trägersubstrat 8. Die Montagelöcher 12 sind nur im überstehenden Randabschnitt 24 der Deckplatte 8 verteilt ausgebildet. Dies hat den Vorteil, dass die Prozessierung der Solarzellen 6 in herkömmlicher Weise erfolgen kann, wobei lediglich eine Deckplatte 8 mit vorgebohrten Montagelöchern 12 zur Laminierung mit dem Trägersubstrat 7 vorzusehen ist. Gleichermaßen ist es auch möglich, die Montagelöcher 12 nachträglich im laminierten Solarmodul 2 in den überstehenden Randabschnitt 24 einzuarbeiten. Eine Entschichtung im Bereich der Solarzellen 6 ist nicht erforderlich, so dass keine photovoltaisch aktive Fläche verloren geht und der Herstellungsprozess vereinfacht ist. Wie in Fig. 7B veranschaulicht, kann eine Verschraubung mit einem Modulhalter 5 oder alternativ mit einer Verbindungslasche 23 wie in der bereits zuvor beschriebenen Weise erfolgen. Denkbar wäre auch, die Montagelöcher 12 alternativ in einem überstehenden Randabschnitt des Trägersubstrats 7 auszubilden.

Wie sich aus vorstehender Beschreibung ergibt, stellt die Erfindung ein rahmenloses Dünnschichtsolarmodul zur Verfügung, das eine einfache, zuverlässige und kostengünstige Montage an einer Modulhalterung oder die Verbindung mit weiteren Solarmodulen in Form einer freitragenden Konstruktion ermöglicht. Insbesondere können gleiche Solarmodule wahlweise zur Aufdach- oder Indach-Montage oder für eine freitragende Konstruktion verwendet werden. Zudem ist ein einfacher und kostengünstiger Austausch von Solarmodulen ermöglicht. Eine Diebstahlsicherung kann in einfacher Weise beispielsweise durch die Verwendung von Schlossschrauben oder das Herstellen einer nichtlösbaren Verbindung von Schraubenbolzen und Gegenmuttern, beispielsweise durch Verschweißung, erreicht werden. Werden die Montagelöcher im photovoltaisch aktiven Bereich der Solarmodule vorgesehen, ist die Modulleistung zwangsläufig etwas geringer als bei vergleichbaren Solarmodulen mit herkömmlicher Rückseitenmontagetechnik, da Solarzellenfläche beansprucht wird. Abhängig von der Modulgröße, beträgt in einem Solarmodul mit einer Fläche von ca. 66 x 154 cm die Leistungseinbuße durch vier beschichtungsfreie Zonen mit einer jeweiligen Fläche von ca. 4 x 4 cm ca. 1-2 %. Bei einem Solarmodul, in dem die Montagelöcher im überstehenden Randabschnitt der Deckplatte (bzw. Trägersubstrat) ausgebildet sind, tritt kein Leistungsverlust auf, wobei dann aber eine entsprechend größere Deckplatte (bzw. Trägersubstrat) vorzusehen ist.

## Patentansprüche

1. Rahmenloses Dünnschichtsolarmodul (2), mit einem Trägersubstrat (7) und einer damit verbundenen Deckschicht (8), zwischen denen sich ein Schichtenaufbau (9) befindet, durch den eine Serienverschaltung aus einer Mehrzahl erster und zweiter Solarzellen (6, 6') zur photovoltaischen Energieerzeugung gebildet wird, wobei das Trägersubstrat (7) und/oder die Deckschicht (8) mit Montagelöchern (12) zur Montage des Solarmoduls an einer Modulhalterung (3) oder zur Verbindung mit zumindest einem weiteren Solarmodul versehen ist, wobei die Montagelöcher (12) jeweils in einer beschichtungsfreien Zone (14) innerhalb eines photovoltaisch aktiven Bereichs (13) ausgebildet sind, wobei die ersten und zweiten Solarzellen (6, 6') eine zueinander gleiche Solarzellenfläche aufweisen, **dadurch gekennzeichnet, dass**:
die ersten Solarzellen (6) rechteckig sind, eine zueinander gleiche Form haben und jeweils aus einem Abschnitt des Schichtenaufbaus (9) hergestellt sind, in dem sich keine beschichtungsfreie Zone (14) befindet;
die zweiten Solarzellen (6') rechteckig sind, eine zueinander gleiche Form haben und jeweils aus einem Abschnitt des Schichtenaufbaus (9) hergestellt sind, in dem sich wenigstens eine beschichtungsfreie Zone (14) befindet;
wobei eine Länge der zweiten Solarzellen (6') kleiner ist als eine Länge der ersten Solarzellen (6) und eine Breite der zweiten Solarzellen (6') größer ist als eine Breite der ersten Solarzellen (6).

2. Rahmenloses Dünnschichtsolarmodul (2) nach Anspruch 1, bei welchem an jedem Montageloch (12) eine das Montageloch (12) umlaufend zum Schichtenaufbau (9) hin abdichtende Dichtmasse (16) zwischen Trägersubstrat (7) und Deckschicht (8) angeordnet ist.

3. Montageanordnung (1) mit wenigstens einem rahmenlosen Dünnschichtsolarmodul (2) nach einem der Ansprüche 1 bis 2, bei welcher das Dünnschichtsolarmodul (2) durch die Montagelöcher (12) durchsetzende Befestigungselemente, beispielsweise Schraubbolzen (17), an der Modulhalterung (3) montiert ist.

4. Montageanordnung (1) nach Anspruch 3, bei welcher an den Montagelöchern (12) jeweils eine Lage (21) aus elastisch nachgiebigem Material zwischen dem Befestigungselement (17) und dem Dünnschichtsolarmodul (2) und/oder zwischen dem Dünnschichtsolarmodul (2) und der Modulhalterung (3) angeordnet ist.

5. Montageanordnung (1) mit rahmenlosen Dünnschichtsolarmodulen (2) nach einem der Ansprüche 1 bis 2, bei welcher benachbarte Dünnschichtsolarmodule (2) durch Verbindungselemente (23), welche an den Dünnschichtsolarmodulen (2) durch die Montagelöcher (12) durchsetzende Befestigungselemente, beispielsweise Schraubbolzen (17), montiert sind, miteinander verbunden sind.

6. Montageanordnung (1) nach Anspruch 5, bei welcher Fugen (25) zwischen benachbarten Dünnschichtsolarmodulen (2) durch Dichtelemente (22) abgedichtet sind.

7. Verfahren zur Herstellung eines rahmenlosen Dünnschichtsolarmoduls (2), mit einem Trägersubstrat (7) und einer damit verbundenen Deckschicht (8), zwischen denen sich ein Schichtenaufbau (9) befindet, durch den eine Serienverschaltung aus einer Mehrzahl erster und zweiter Solarzellen (6, 6') zur photovoltaischen Energieerzeugung gebildet wird, wobei das Trägersubstrat (7) und/oder die Deckschicht (8) mit Montagelöchern (12) zur Montage des Solarmoduls an einer Modulhalterung (3) oder zur Verbindung mit zumindest einem weiteren Solarmodul versehen wird, wobei die Montagelöcher (12) jeweils in einer beschichtungsfreien Zone (14) des Schichtenaufbaus (9) ausgebildet werden; wobei der Schichtenaufbau (9) in die Montagelöcher (12) enthaltenden oder zur Ausbildung der Montagelöcher (12) vorgesehenen Zonen (14) entfernt wird; wobei die ersten und zweiten Solarzellen (6, 6') eine zueinander gleiche Solarzellenfläche aufweisen;
**dadurch gekennzeichnet, dass**:
die ersten Solarzellen (6) rechteckig sind, eine zueinander gleiche Form haben und jeweils aus einem Abschnitt des Schichtenaufbaus (9) hergestellt werden, in dem sich keine beschichtungsfreie Zone (14) befindet;
die zweiten Solarzellen (6') rechteckig sind, eine zueinander gleiche Form haben und jeweils aus einem Abschnitt des Schichtenaufbaus (9) hergestellt werden, in dem sich wenigstens eine beschichtungsfreie Zone (14) befindet;
wobei eine Länge der zweiten Solarzellen (6') kleiner ist als eine Länge der ersten Solarzellen (6) und eine Breite der zweiten Solarzellen (6') größer ist als eine Breite der ersten Solarzellen (6).

8. Verfahren nach Anspruch 7, bei welchem die Montagelöcher (12) vor dem Aufbringen des Schichtenaufbaus (9) auf das Trägersubstrat (7) im Trägersubstrat (7) und/oder in der Deckschicht (8) ausgebildet werden.

9. Verfahren nach einem der Ansprüche 7 oder 8, bei welchem an jedem Montageloch (12) eine das Montageloch (12) umlaufend zum Schichtenaufbau (9) hin abdichtende Dichtmasse (16) zwischen Trägersubstrat (7) und Deckschicht (8) angeordnet wird.

10. Verfahren nach einem der Ansprüche 7 bis 9, bei welchem in die Montagelöcher (12) jeweils eine Dichtmasse (16') eingebracht wird.

## Claims

1. Frameless thin-film solar module (2), with a carrier substrate (7) and a cover layer (8) connected thereto, between which a layer structure (9) is situated, by which a series connection of a plurality of first and second solar cells (6, 6') for photovoltaic energy generation is formed, wherein the carrier substrate (7) and/or the cover layer (8) is provided with mounting holes (12) for mounting the solar module to a module holder (3) or for connecting to at least one additional solar module, wherein the mounting holes (12) are in each case implemented in a coating-free zone (14) within a photovoltaically active region (13), wherein the first and second solar cells (6, 6') have a similar solar cell area, **characterized in that**:
the first solar cells (6) are rectangular, have the same shape and respectively are produced from a section of the layer structure (9) in which no coating-free zone (14) is situated;
the second solar cells (6') are rectangular, have the same shape and respectively are produced from a section of the layer structure (9) in which at least one coating-free zone (14) is situated;
wherein a length of the second solar cells (6') is smaller than a length of the first solar cells (6) and a width of the second solar cells (6') is greater than a width of the first solar cells (6).

2. Frameless solar module (2) according to claim 1, wherein, on each mounting hole (12) a sealant (16) sealing the mounting hole (12) circumferentially relative to the layer structure (9) is disposed between the carrier substrate (7) and the cover layer (8).

3. Mounting arrangement (1) comprising at least one frameless thin-film solar module (2) according to one of claims 1 through 2, wherein the solar module (2) is mounted to the module holder (3) by fastening elements, for example, bolts (17), passing through the mounting holes (12).

4. Mounting arrangement (1) according to claim 3, wherein at the mounting holes (12) in each case a layer (21) made of an elastically flexible material is disposed between the fastening element (17) and the solar module (2) and/or between the solar module (2) and the module holder (3).

5. Mounting arrangement (1) with frameless thin-film solar modules (2) according to one of claims 1 through 2, wherein adjacent solar modules (2) are connected to each other by connecting elements (23) that are mounted to the solar modules (2) by fastening elements, for example, bolts (17), passing through the mounting holes (12).

6. Mounting arrangement (1) according to claim 5, wherein joints (25) between adjacent solar modules (2) are sealed by sealing elements (22).

7. Method for producing a frameless thin-film solar module (2), with a carrier substrate (7) and a cover layer (8) connected thereto, between which a layer structure (9) is situated, by which a series connection of a plurality of first and second solar cells (6, 6') for photovoltaic energy generation is formed, wherein the carrier substrate (7) and/or the cover layer (8) is provided with mounting holes (12) for mounting the solar module to a module holder (3) or for connecting to at least one additional solar module, wherein the mounting holes (12) are formed in each case in a coating-free zone (14) of the layer structure (9);
wherein
the layer structure (9) is removed in zones (14) containing the mounting holes (12) or provided for implementation of the mounting holes (12);
wherein the first and second solar cells (6, 6') have a similar solar cell area;
**characterized in that**:
the first solar cells (6) are rectangular, have the same shape and are in each case produced from a section of the layer structure (9) in which no coating-free zone (14) is situated;
the second solar cells (6') are rectangular, have the same shape and are produced in each case from a section of the layer structure (9) in which at least one coating-free zone (14) is situated;
wherein a length of the second solar cells (6') is smaller than a length of the first solar cells (6) and a width of the second solar cells (6') is greater than a width of the first solar cells (6).

8. Method according to claim 7, wherein the mounting holes (12) are implemented in the carrier substrate (7) and/or in the cover layer (8) before the application of the layer structure (9) on the carrier substrate (7).

9. Method according to one of claims 7 or 8, wherein at each mounting hole (12) a sealant (16) sealing the mounting hole (12) circumferentially relative to the layer structure (9) is disposed between the carrier substrate (7) and the cover layer (8).

10. Method according to one of claims 7 through 9, wherein, in each case, a sealant (16') is introduced into the mounting holes (12).

## Revendications

1. Module solaire sans cadre à couches minces (2), avec un substrat porteur (7) et une couche supérieure associée (8) avec celui-ci, entre lesquels se trouve une structure en couches (9), par le biais de laquelle est formée une connexion en série d'une pluralité de premières et de deuxièmes cellules solaires (6, 6') pour la production d'énergie photovoltaïque, où le substrat porteur (7) et/ou la couche de surface (8) est pourvue d'orifices de montage (12) pour le montage du module solaire à un support de module (3), ou pour la connexion avec au moins un autre module solaire, où les orifices de montage (12) sont respectivement formés dans une zone sans revêtement (14) à l'intérieur d'une zone active photovoltaïque (13), où les premières et les deuxièmes cellules solaires (6, 6') présentent une surface de cellule solaire identique entre elles, **caractérisé en ce que** :
les premières cellules solaires (6) sont rectangulaires, ont une forme identique entre elles et sont fabriquées respectivement à partir d'une section de la structure en couches (9), dans lequel il n'y a aucune zone sans revêtement (14) ;
les deuxièmes cellules solaires (6') sont rectangulaires, ont une forme identique entre elles et sont fabriquées respectivement à partir d'une section de la structure en couches (9), dans lequel il y a au moins une zone sans revêtement (14) ;
où une longueur des deuxièmes cellules solaires (6') est inférieure à une longueur des premières cellules solaires (6) et une largeur des deuxièmes cellules solaires (6') est supérieure à une largeur des premières cellules solaires (6).

2. Module solaire sans cadre à couches minces (2) selon la revendication 1, dans lequel sur chaque orifice de montage (12) une masse d'étanchéité (16) entourant l'orifice de montage (12) et le rendant étanche vers la structure en couches (9) est disposée entre le substrat porteur (7) et (8) la couche supérieure.

3. Agencement de montage (1) avec au moins un module solaire sans cadre à couches minces (2) selon l'une des revendications 1 ou 2, où le module solaire à couches minces (2) est monté sur le support de module (3), au moyen d'éléments de fixation traversant les orifices de fixation (12), tels que des boulons (17).

4. Agencement de montage (1) selon la revendication 3, où respectivement une couche (21) en matériau élastiquement souple est disposée contre les orifices de montage (12) entre l'élément de fixation (17) et le module solaire à couches minces (2) ou entre les modules solaires à couches minces (2) et le support de modules (3).

5. Agencement de montage (1) avec des modules solaires sans cadre à couches minces (2) lorsqu'une quelconque des revendications 1 ou 2, dans lequel des modules solaires à couches minces (2) voisins sont reliés entre eux par des éléments de fixation (23), qui sont montés sur les modules solaires à couches minces (2) au moyen d'éléments de fixation traversant les orifices de fixation (12), tels que des boulons (17).

6. Agencement de montage (1) selon la revendication 5, dans lequel des joints (25) entre des modules solaires à couches minces (2) voisins sont scellés par des éléments d'étanchéité (22).

7. Procédé de fabrication d'un module solaire sans cadre à couches minces (2), avec un substrat porteur (7) et une couche supérieure associée (8) avec celui-ci, entre lesquels se trouve une structure en couches (9), par le biais de laquelle est formée une connexion en série d'une pluralité de premières et de deuxièmes cellules solaires (6, 6') pour la production d'énergie photovoltaïque, où le substrat porteur (7) et/ou la couche de surface I(8) est pourvue d'orifices de montage (12) pour le montage du module solaire à un support de module (3), ou pour la connexion avec au moins un autre module solaire, où les orifices de montage (12) sont respectivement formés dans une zone sans revêtement (14) de la structure en couches (9) ;
où la structure en couches (9) est enlevée dans les zones (14) contenant les orifices de montage (12) ou destinés à la formation d'orifices de montage (12) ;
où les premières et les deuxièmes cellules solaires (6, 6') présentent une surface de cellule solaire identique entre elles ;
**caractérisé en ce que**
les premières cellules solaires (6) sont rectangulaires, ont une forme identique entre elles et sont fabriquées respectivement à partir d'une section de la structure en couches (9), dans lequel il n'y a aucune zone sans revêtement (14);
les deuxièmes cellules solaires (6') sont rectangulaires, ont une forme identique entre elles et sont fabriquées respectivement à partir d'une section de la structure en couches (9), dans lequel il y a au moins une zone sans revêtement (14);
où une longueur des deuxièmes cellules solaires (6') est inférieure à une longueur des premières cellules solaires (6) et une largeur des deuxièmes cellules solaires (6') est supérieure à une largeur des premières cellules solaires (6).

8. Procédé selon la revendication 7, dans lequel les orifices de montage (12) sont formés avant l'application de la structure en couches (9) sur le substrat porteur (7) dans le substrat porteur (7) et/ou dans la couche supérieure (8).

9. Procédé selon l'une des revendications 7 ou 8, dans lequel sur chaque orifice de montage (12) une masse d'étanchéité (16) entourant l'orifice de montage (12), et le rendant étanche vers la structure en couches (9) est disposée entre le substrat porteur (7) et (8) la couche supérieure.

10. Procédé selon l'une des revendications 7 à 9, dans lequel une masse d'étanchéité (16') est introduite respectivement dans les trous de montage (12).
